# EUROPÄISCHE PATENTANMELDUNG

(11) **EP 1 174 882 A1**
(43) Veröffentlichungstag der Anmeldung: **23.01.2002**
(21) Anmeldenummer: 01113927.6
(22) Anmeldetag: 07.06.2001
(51) Int. Cl.: G11C 11/16

(54) **MRAM-Anordnung**

(30) Priorität: 03.07.2000 DE 10032271
(71) Anmelder: Infineon Technologies AG, 81669 München (DE)
(72) Erfinder: Boehm, Thomas, 85604 Zorneding (DE); Kandolf, Helmut, 81669 München (DE); Lammers, Stefan, 81739 München (DE)
(74) Vertreter: Müller . Hoffmann & Partner Patentanwälte

(57) **Zusammenfassung**

Die Erfindung betrifft eine MRAM-Anordnung, bei der Leitungstreiberschaltungen (6, 7) jeweils über Verbindungsknoten (4, 5) zwei Speicherzellenfeldern (1, 2 bzw. 2, 3) zugeordnet sind, so daß die Fläche für die Treiberschaltungen praktisch halbiert werden kann.

## Beschreibung

Die Erfindung betrifft eine MRAM-Anordnung (MRAM = magnetoresistiver RAM bzw. Speicher) aus wenigstens zwei Speicherzellenfeldern, in denen jeweils Speicherzellen an den Kreuzungen von Wortleitungen mit Bitleitungen vorgesehen sind, wobei mindestens eine Leitungsart aus den Wortleitungen und Bitleitungen mit Leitungstreiberschaltungen versehen ist.

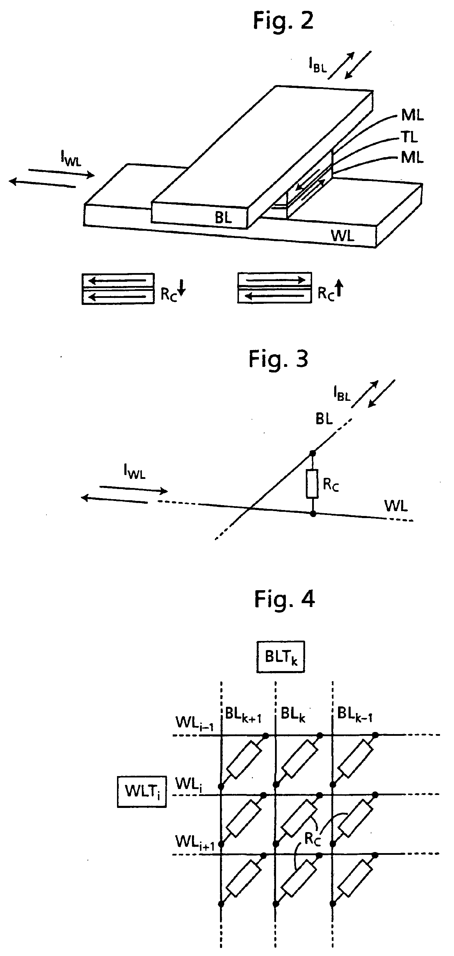

Bekanntlich beruht der Speichereffekt von MRAMs auf einem veränderbaren Widerstand der einzelnen Speicherzellen dieser Speicher. Der Aufbau einer solchen MRAM-Speicherzelle soll zunächst im folgenden anhand der Figuren 2 und 3 erläutert werden, von denen Fig. 3 ein Ersatzschaltbild der in Fig. 2 dargestellten Speicherzelle zeigt.

Eine MRAM-Speicherzelle befindet sich an der Kreuzungsstelle zweier Leitungen, nämlich insbesondere einer Wortleitung WL mit einer Bitleitung BL. Die Speicherzelle selbst besteht aus zwei magnetischen Schichten ML, die durch eine dünne dielektrische Schicht TL voneinander getrennt sind.

Der Wert des elektrischen Widerstandes einer solchen MRAM-Speicherzelle hängt nun von der Polarisierung der magnetischen Schichten ML ab. Sind beide Schichten ML in der gleichen Richtung polarisiert, so liegt in der Speicherzelle ein niedriger Wert R_{C}↓ vor, während bei zueinander entgegengesetzter Polarisierung der beiden magnetischen Schichten ML ein hoher Wert R_{C}↑ des elektrischen Widerstandes erhalten wird. Mit anderen Worten, in Abhängigkeit von der Polarisierung der magnetischen Schichten ML ergibt sich ein hoher (↑) oder niedriger (↓) Widerstandswert für die Speicherzelle aus den beiden magnetischen Schichten ML und der dazwischenliegenden dielektrischen Schicht TL.

Von den magnetischen Schichten ML besteht eine Schicht aus einem weichmagnetischen Material, während die andere Schicht aus einem hartmagnetischen Material hergestellt ist. Das weichmagnetische Material ist so gewählt, daß es durch einen Schreibstrom auf der Wortleitung WL und der Bitleitung BL umpolarisiert werden kann, während bei dem hartmagnetischen Material eine solche Umpolarisation durch die Schreibströme nicht möglich sein soll.

Damit nun die magnetische Schicht ML aus weichmagnetischem Material in zwei entgegengesetzte Richtungen polarisiert werden kann, ist es erforderlich, daß mindestens einer von zwei Programmierströmen I_{BL} durch die Bitleitung BL oder I_{WL} durch die Wortleitung WL in beiden Richtungen durch die jeweilige Leitung WL bzw. BL fließen kann. Denn nur dann kann an der Kreuzungsstelle der Wortleitung WL mit der Bitleitung BL dafür gesorgt werden, daß bei entsprechend gerichteten Programmierströmen I_{BL} und I_{WL} an der Kreuzungsstelle das Magnetfeld für eine Umpolarisation in der magnetischen Schicht ML aus weichmagnetischem Material für die Umpolarisation ausreichend stark ist.

Die Ströme, die durch die Speicherzelle fließen, sind Tunnelströme durch die dünne dielektrische Schicht TL, so daß ein "magnetischer Tunnelübergang" bzw. "Tunnel-Junction" vorliegt, weshalb die MRAM-Speicherzelle auch als MTJ-Speicherzelle bezeichnet wird.

Fig. 4 zeigt ein MRAM-Speicherzellenfeld aus Wortleitungen WLᵢ₋₁, WLᵢ und WLᵢ₊₁ sowie Bitleitungen BLₖ₊₁, BLₖ und BLₖ₋₁ sowie MTJ-Speicherzellen mit jeweiligen Widerständen R_{c} an den Kreuzungsstellen dieser Leitungen.

Die Wortleitungen WL und die Bitleitungen BL sind bei einem solchen Speicherzellenfeld jeweils mit Wortleitungstreiberschaltungen und Bitleitungstreiberschaltungen versehen, die an ihre zugeordnete Wortleitung bzw. Bitleitung einen entsprechenden Programmier- bzw. Lesestrom abgeben. In Fig. 4 ist ein solcher Wortleitungstreiber WLTᵢ bzw. Bitleitungstreiber BLTₖ für die Wortleitung WLᵢ bzw. die Bitleitung BLₖ schematisch gezeigt. Solche Wortleitungstreiber bzw. Bitleitungstreiber sind für das gesamte Speicherzellenfeld aus m Wortleitungen und n Bitleitungen für jede Wortleitung bzw. Bitleitung vorhanden. Dabei müssen wenigstens an einer der beiden Leitungen, also entweder wenigstens an den Wortleitungen oder wenigstens an den Bitleitungen zwei Treiber vorgesehen werden, nämlich an jedem Ende dieser Leitungen jeweils ein Treiber, damit der durch die Leitungen führende Strom in jede Richtung der jeweiligen Leitung getrieben werden kann.

Bei einer MRAM-Anordnung treten an einer selektierten Wortleitung oder Bitleitung hohe parasitäre Ströme auf, die letztlich durch die zahlreichen Kreuzungsstellen beispielsweise einer selektierten Wortleitung WL mit den sie kreuzenden n Bitleitungen bedingt sind. Aufgrund dieser hohen parasitären Ströme kann daher eine große MRAM-Anordnung nur aus mehreren kleineren Speicherzellenfeldern aufgebaut werden. Dies bedeutet aber, daß bei jedem Speicherzellenfeld aus beispielsweise m Wortleitungen und n Bitleitungen insgesamt 2m + n oder 2 n + m Leitungstreiberschaltungen erforderlich sind. Für die MRAM-Anordnung insgesamt, die beispielsweise aus 1 Speicherzellenfeldern besteht, werden dann 1(2m + n) oder 1(2n + m) Leitungstreiberschaltungen benötigt. Für diese Leitungstreiberschaltungen wird auf einem die MRAM-Anordnung beinhaltenden Chip aber viel Fläche benötigt, was äußerst unerwünscht ist.

Es ist daher Aufgabe der vorliegenden Erfindung, eine MRAM-Anordnung anzugeben, bei der der Flächenbedarf für die Leitungstreiberschaltungen durch deren effektive Zuordnung reduziert ist, so daß eine platzsparende Architektur erhalten wird.

Diese Aufgabe wird bei einer MRAM-Anordnung der eingangs genannten Art erfindungsgemäß dadurch gelöst, daß die Leitungstreiberschaltungen jeweils an Verbindungsknoten zwischen zwei Speicherzellenfeldern angeschlossen sind und zwischen dem Verbindungsknoten und den beiden Speicherzellenfeldern jeweils ein Schalttransistor liegt.

Durch diese Gestaltung der MRAM-Anordnung wird grundsätzlich von einer naheliegenden Lösung obiger Problematik abgewichen, bei der davon ausgegangen wird, jeweils an jedem Ende eines Speicherzellenfeldes eine Stromquelle bzw. Stromsenke zu plazieren: vielmehr werden bei der erfindungsgemäßen MRAM-Anordnung die Leitungstreiberschaltungen so angeordnet, daß sie verschiedenen Speicherzellenfeldern zugeordnet werden können, was letztlich ungefähr eine Halbierung der insgesamt benötigten Leitungstreiberschaltungen gegenüber dem Stand der Technik bedeutet. Ebenso kann der Aufwand für die Stromquellen in den Leitungstreiberschaltungen reduziert werden, da bei der vorliegenden Erfindung eine Stromquelle zwei Speicherquellenfeldern zugewiesen ist.

In einer Weiterbildung der Erfindung ist vorgesehen, daß der Verbindungsknoten zwischen zwei Speicherzellenfeldern über ein Element mit einstellbarem Spannungsabfall mit Massepotential verbunden ist. Damit gelangt ein Schreibstrom nach Durchqueren eines Speicherzellenfeldes über den ausgangsseitigen Verbindungsknoten dieses Speicherzellenfeldes und das Element mit einstellbarem Spannungsabfall ohne weiteres auf das Massepotential. Dieser einstellbare Spannungsabfall kann beispielsweise durch einen veränderbaren Widerstand, eine variable Transistordiode oder eine einstellbare Spannungsquelle erzeugt werden. Die dadurch einstellbare Spannung sorgt dafür, daß parasitäre Ströme durch die mit der selektiven Wort- oder Bitleitung verbundenen Speicherzellen minimiert werden können.

Für die Leitungstreiberschaltungen wird in vorteilhafter Weise jeweils eine Reihenschaltung aus einer Stromquelle mit einem Schreibtreibertransistor verwendet. Für diesen Schreibtreibertransistor kann beispielsweise ein n-Kanal-MOS-Feldeffekttransistor gewählt werden, was im übrigen auch für den Schalttransistor und die Transistordiode gilt.

Nachfolgend wird die Erfindung anhand der Zeichnungen näher erläutert. Es zeigen:
- Fig. 1: ein Blockschaltbild zur Erläuterung der erfindungsgemäßen MRAM-Anordnung,
- Fig. 2: eine schematische Darstellung einer MTJ-Speicherzelle,
- Fig. 3: ein Ersatzschaltbild für die MTJ-Speicherzelle von Fig. 2 und
- Fig. 4: ein MRAM-Speicherzellenfeld mit MTJ-Speicherzellen an den Kreuzungsstellen zwischen Wortleitungen und Bitleitungen.

Die Figuren 2 bis 4 sind bereits eingangs erläutert worden.

In den Figuren werden für einander entsprechende Bauteile jeweils die gleichen Bezugszeichen verwendet.

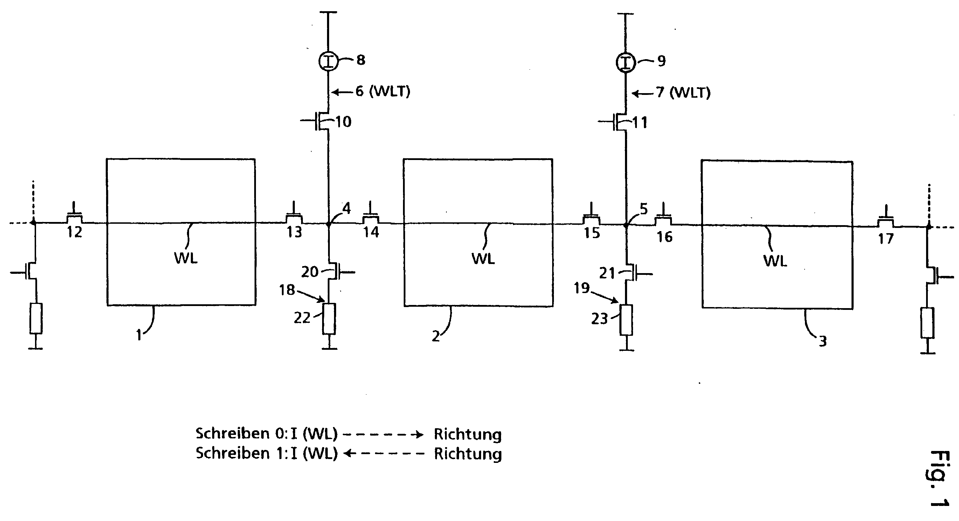

Fig. 1 zeigt ein Blockschaltbild der erfindungsgemäßen MRAM-Anordnung aus drei Speicherzellenfeldern 1, 2, 3, die jeweils in der in Fig. 4 gezeigten Weise aufgebaut sind und aus MTJ-Speicherzellen der in Fig. 2 bzw. 3 gezeigten Art an den Kreuzungsstellen zwischen Wortleitungen WL und Bitleitungen BL bestehen. Anstelle von drei Speicherzellenfeldern kann selbstverständlich auch eine größere Anzahl von Speicherzellenfeldern vorgesehen werden.

Weiterhin zeigt Fig. 1 eine MRAM-Anordnung, bei der die Speicherzellenfelder 1 bis 3 durch gemeinsame Wortleitungen WL (zur Vereinfachung der Darstellung ist lediglich eine Wortleitung WL gezeigt) durchsetzt sind. Selbstverständlich können auch mehrere Speicherzellenfelder mit gemeinsamen Bitleitungen oder mit gemeinsamen Wortleitungen und gemeinsamen Bitleitungen versehen sein.

Bei der MRAM-Anordnung des Ausführungsbeispiels von Fig. 1 sind Verbindungsknoten 4, 5 zwischen den Speicherzellenfeldern 1 und 2 bzw. zwischen den Speicherzellenfeldern 2 und 3 jeweils an eine Wortleitungstreiber-Schaltung 6 bzw. 7 angeschlossen. Diese Wortleitungstreiberschaltungen 6 und 7 bestehen aus Treiberstromquellen 8 bzw. 9 und Schreibtreibertransistoren 10 bzw. 11. Die Treiberstromquellen 8 und 9 können dabei in der in Fig. 1 gezeigten Weise gepolt sein. Für die Schreibtreibertransistoren 10 und 11 können beispielsweise n-Kanal-MOS-Transistoren verwendet werden.

Weiterhin sind bei der erfindungsgemäßen MRAM-Anordnung zwischen den einzelnen Verbindungsknoten 4 und 5 sowie den Speicherzellenfeldern 1 bis 3 jeweils Schalttransistoren 12 bis 17 vorgesehen. Die Schalttransistoren 12 und 13 sind dabei dem Speicherzellenfeld 1 zugeordnet, während die Schalttransistoren 14 und 15 zu dem Speicherzellenfeld 2 gehören und die Schalttransistoren 16 und 17 für das Speicherzellenfeld 3 vorgesehen sind.

Schließlich sind die Verbindungsknoten 4 und 5 noch jeweils über ein Element 18 bzw. 19 mit einstellbarem Spannungsabfall mit Massepotential verbunden. Dieses Element 18 bzw. 19 kann aus einer variablen Transistordiode 20 bzw. 21 und einer einstellbaren Spannungsquelle 22 bzw. 23 bestehen.

Anstelle einer variablen Transistordiode kann auch ein veränderbarer Widerstand vorgesehen werden.

Es sei angenommen, daß bei der MRAM-Anordnung von Fig. 1 die Stromrichtung zum Einschreiben einer "0" in mit der Wortleitung WL verbundene Speicherzellen der Speicherzellenfelder 1 bis 3 jeweils von links nach rechts verläuft, während zum Einschreiben einer "1" in diese Speicherzellen der Speicherzellenfelder 1 bis 3 ein Stromfluß von rechts nach links erforderlich ist, wie dies durch Pfeile angedeutet ist. Die gleiche Vereinbarung soll selbstverständlich für die übrigen Wortleitungen WL dieser Speicherzellenfelder, die nicht näher gezeigt sind, gelten. In den jeweiligen Bitleitungen BL muß zum Schreiben dabei ein entsprechender Strom fließen.

Bei der MRAM-Anordnung von Fig. 1 wird unter den obigen Annahmen die Stromquelle 8 zum Einschreiben einer "1" in das Speicherzellenfeld 1 und zum Einschreiben einer "0" in das Speicherzellenfeld 2 verwendet. In ähnlicher Weise dient die Stromquelle 9 zum Einschreiben einer "1" in das Speicherzellenfeld 2 und zum Einschreiben einer "0" in das Speicherzellenfeld 3.

Soll beispielsweise eine "1" in das Speicherzellenfeld 2, d. h. eine mit der Wortleitung WL verbundene Speicherzelle dieses Speicherzellenfeldes 2 eingeschrieben werden, so wird der hierfür erforderliche Schreibstrom von der Stromquelle 2 geliefert. Der Schreibtreibertransistor 11 wird in den leitenden Zustand gebracht, in welchem er über den Verbindungsknoten 5 eine "1" in das Speicherzellenfeld 2 und eine "0" in das Speicherzellenfeld 3 einspeisen kann. Damit tatsächlich die "1" in das Speicherzellenfeld 2 und nicht die "0" in das Speicherzellenfeld 2 eingeschrieben wird, wird der Schalttransistor 15 in den leitenden Zustand gebracht, während der Schalttransistor 16 in den nichtleitenden Zustand angesteuert wird.

Der Schreibstrom gelangt dann durch das Speicherzellenfeld 2, in welchem er eine an einer Kreuzungsstelle der Wortleitung WL mit einer ebenfalls angesteuerten Bitleitung liegende Speicherzelle umpolarisiert, über den im leitenden Zustand befindlichen Schalttransistor 14 bei gesperrten Transistoren 10 und 13 und über das Element 18 mit einstellbarem Spannungsabfall auf Massepotential.

Der Transistor 20 befindet sich so im leitenden Zustand, wenn in das Speicherzellenfeld 2 eine "1" oder in das Speicherzellenfeld 1 eine "0" eingeschrieben wird. Durch entsprechende Einstellung des Spannungsabfalles über der veränderlichen Spannungsquelle 22 wird erreicht, daß der parasitäre Strom durch die Speicherzellen der selektierten Wortleitung WL minimiert ist.

Bei der MRAM-Anordnung wird also durch entsprechende Stellung der durch die Schalttransistoren 12 bis 17 gebildeten Schalter ein Speicherzellenfeld 1 bis 3 ausgewählt. Wichtig ist dabei, daß alle nicht selektierten Wort- und Bitleitungen des ausgewählten Speicherzellenfeldes vor dem eigentlichen Schreibvorgang auf ein definiertes Potential gelegt werden, damit die parasitären Ströme minimiert bzw. eliminiert sind.

Da bei der erfindungsgemäßen MRAM-Anordnung die Leitungstreiberschaltungen 6 und 7 gemeinsam für jeweils zwei Speicherzellenfelder 1 und 2 bzw. 2 und 3 eingesetzt werden, ist eine erhebliche Reduzierung der erforderlichen Chipfläche möglich. Eine weitere Verringerung der Chipfläche kann erreicht werden, wenn anstelle der im Ausführungsbeispiel von Fig. 1 gezeigten n-Kanal-MOS-Transistoren jeweils geboostete Schalter eingesetzt werden.

## Patentansprüche

1. MRAM-Anordnung aus wenigstens zwei Speicherzellenfeldern (1, 2, 3), in denen jeweils Speicherzellen an den Kreuzungen von Wortleitungen (WL) mit Bitleitungen (BL) vorgesehen sind, wobei mindestens eine Leitungsart aus den Wortleitungen (WL) und den Bitleitungen (BL) mit Leitungstreiberschaltungen (6, 7) versehen ist,
**dadurch gekennzeichnet,**
**dass** die Leitungstreiberschaltungen (6, 7) jeweils an Verbindungsknoten (4, 5) zwischen zwei Speicherzellenfeldern (1, 2 bzw. 2, 3) angeschlossen sind und zwischen dem Verbindungsknoten (4 bzw. 5) und den beiden Speicherzellenfeldern (1, 2 bzw. 2, 3) jeweils ein Schalttransistor (13, 14 bzw. 15, 16) liegt, so dass die Leitungstreiberschaltungen (6, 7) jeweils verschiedenen Speicherzellenfeldern (1, 2) zugeordnet sind.

2. MRAM-Anordnung nach Anspruch 1,
**dadurch gekennzeichnet,**
**daß** der Verbindungsknoten (4, 5) über ein Element (18, 19) mit einstellbarem Spannungsabfall mit Massepotential verbunden ist.

3. MRAM-Anordnung nach Anspruch 2,
**dadurch gekennzeichnet,**
**daß** das Element (18, 19) mit einstellbarem Spannungsabfall einen Transistor (20, 21) und einen veränderbaren Widerstand, eine variable Transistordiode oder eine einstellbare Spannungsquelle (22, 23) aufweist.

4. MRAM-Anordnung nach einem der Ansprüche 1 bis 3,
**dadurch gekennzeichnet,**
**daß** die Leitungstreiberschaltungen (6, 7) jeweils aus einer Reihenschaltung einer Stromquelle (8, 9) mit einem Schreibtreibertransistor (10, 11) bestehen.

5. MRAM-Anordnung nach einem der Ansprüche 1 bis 4,
**dadurch gekennzeichnet,**
**daß** die Schalttransistoren (12 bis 17), die Transistoren (20, 21) und die Schreibtreibertransistoren (10, 11) wenigstens teilweise n-Kanal-MOS-Feldeffekttransistoren sind.

6. MRAM-Anordnung nach einem der Ansprüche 1 bis 5, **dadurch gekennzeichnet, daß** eine in einer Leitungstreiberschaltung (6, 7) vorgesehene Stromquelle (8, 9) zwei Speicherquellenfeldern (1, 2 bzw. 2, 3) zugeordnet ist.
